Europäisches Patentamt

European Patent Office

Office européen des brevets

(19)

(11) Publication number: 0 250 376
A2

# EUROPEAN PATENT APPLICATION

(12)

(21) Application number: 87830231.4

(22) Date of filing: 19.06.87

(51) Int. Cl.⁴: H 03 H 2/00

(30) Priority: 20.06.86 IT 4816286

(43) Date of publication of application:
23.12.87 Bulletin 87/52

(84) Designated Contracting States: DE FR GB NL SE

(71) Applicant: SELENIA INDUSTRIE ELETTRONICHE
ASSOCIATE S.p.A.
Via Tiburtina, KM 12.400
I-00131 Roma (IT)

(72) Inventor: De Gasperis, Paolo
Via Umberto Biancamano, 31/A
Roma (IT)

Di Gregorio, Carlo
Via Poggio Fiorito, 53
Grottaferrata Roma (IT)

Miccoli, Giuseppe
Via Vincenzo Tiberio, 64
Roma (IT)

(74) Representative: Emiliani, Gabriele, Ing.
c/o ITALPATENT Via Agri, 3
I-00198 Roma (IT)

(54) Magnetostatic wave constant delay line for microwave circuits through frequency inversion.

(57) Method for the manufacturing of a constant delay line based upon magnetostatic waves, tunable over a wide range of microwave frequencies, which adopts two identical dispersive delay lines made of a magnetic garnet film, characterized by having transfer function $H^*$ (g), which is the complex conjugate on one of them, through a double frequency inversion.

## Description

MAGNETOSTATIC WAVE CONSTANT DELAY LINE FOR MICROWAVE CIRCUITS THROUGH FREQUENCY
INVERSION

This invention regards a planar technology for the manufacturing of constant delay lines. It belongs to the field of technologies dedicated to the processing of microwave frequency signals, with particular reference to systems which require increasing operational frequencies and wider bandwidths. This gives impulse to the search for new techniques and technologies for signal processing.

A new analogue technique makes its appearance on today's scenario for the processing of microware signals, based upon magnetostatic wave MSW propagation in low loss yittrium and Iron garnet magnetic films (YIG, $Y_3 Fe_5 O_{12}$ and derivates by cationic replacement such as La, Ga: YIG) manufactured through liquid Phase Epitaxy (LPE).

MSWs are slow electromagnetic waves which propagate at microwave frequencies within magnetically polarized ferrites. Their main features are:
- Power levels: from the W to the mW range;
- Frequency interval 1-20 $GH_z$
- High coupling efficiency
- Insertion loss: 0.02 dB/nsec
- Instantaneous bandwidth: $\geq$ , GHz
- Dynamic interval: 50dB
- Delay times: from 10 to 1000 nsec/cm;
- External polarizing magnetic field: from 0.1 to 8 10 KOe max.

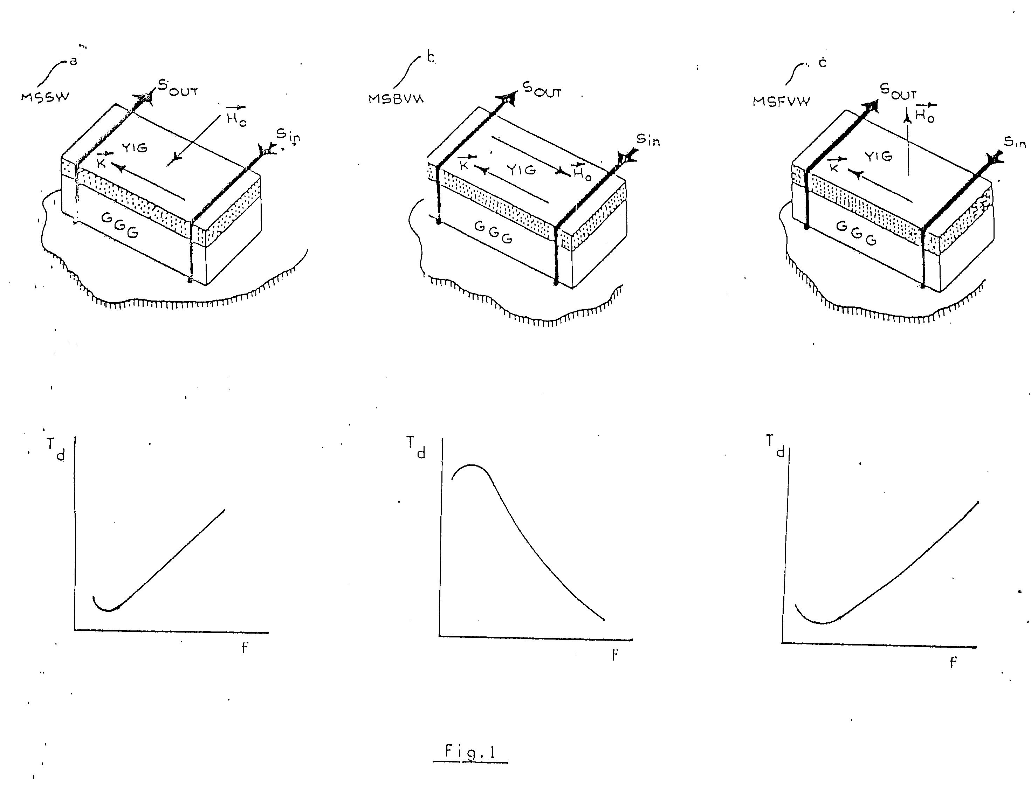

MSWs may be tuned over all microwave frequencies by varying polarizing field $H_o$. Depending on the latter orientation compared to the sample plane, surface models (MSSW) can be generated with progressive (MSFVW) and regressive (MSBVW) waves as shown in Figure 1. In fact Figure 1 shows schematically, the generation of surface magnetostatic waves (a), (b) regressive volume (MSBVW), and (c) progressive volume (MSFVW) magnetostatic waves. For each configuration also the variation of delay line (Td) with frequency (g) is shown.

For MSSW operating devices, the theoretical band falls between frequency limits $\gamma \sqrt{H_o(H_o + 4 M_s)}$ and $\gamma (H_o + 2 M_s)$ where $\gamma$ is the gyromagnetic constant ( $= 2.81$ $mh_z$/Oe for Yig) and $4\pi M_s$ is saturation magnetization ($\simeq$ 1750 gauss for YIG at ambient temperature).

For volume mode operating devices, the lower and high band limits are given respectively by: $\gamma H_i$ and $\gamma \sqrt{H_i(H_i + 4\pi M_s)}$ where $H_i$ is the internal magnetic field (ig. $H_i = H_o$ for $MSBVM_s$ and $H_i = H_o - 4\pi M_s$ for $MSFVN_s$).

For these reasons, by varying polarisation field $H_o$ and therefore propagation vector K, a full set of characteristic curves of the different magnetostatic dispersion modes may be drawn. The most direct consequence of this is that it becomes possible to delay a microwave signal, suitably injected into the epitaxial film through microstriptransducers, directly deposited onto the magnetic film or onto a dielectric support (such as alumina) to be mated with the magnetic film. The relationship between delay and frequency depends on the type of magnetostatic wave induced (as shown in Figure 1). [1] for progressive volumetric waves (MSFVW) an up chirp response is obtained (i.e. increasing delay with increasing frequency) while a down chirp response (decreasing delay with increasing frequency) is obtained for regressive volumetric waves (MSBVW).

Surface waves (MSSW) are always of the up-chirp type.

Based upon such characteristics, in the past a propotype of magnetostatic constant time delay line [2], [3] was developed by cascading two dispersive lines with opposite Td $V_s$f characteristics as tar as possible symmetrical. In the particular case, a MSSW line (up chirp) line was used cascaded with a MSBVW (down chirp) line with magnetic polarising field $H_o$ on the film plane.

The final outcome was a useful band of about 250 $MH_z$ with constant delay, settable within the 165 $\div$ 180 nsec interval as a function of the magnetic polarization imposed upon the regressive type line. Such device operates up to 3.3 $GH_z$, which is the upper limit set by the reduced instantaneous bandwidth at such frequencies by surface waves.

To dispose of devices operating above #GHz, the MSSW line must be replaced with a MSFW line, with an up chirp characteristic and, furthermore, a wide instantaneous bandwidth (of the the order 1 GHz), the centre frequency of which can be tuned to the 20GHz limit. However cascading of MSFVW lines with MSBVW lines gives way to implementation problems, mainly due to the two required different magnetic fields used for polarizing.

In fact, to be generated, MSFVW waves require Ho to be normal to the film plane, while for MSBVW waves, Ho has to be parallel.

Therefore two different polarization fields, in terms of intensity and direction, are required, which makes compactness to the device a problem, as also the simultaneous tuning of two lines over a wide frequency range.

Due to such difficulties, such device cannot be found in literature.

This invention solves all such problems. In fact the method presented gives a volume magnetostatic constant delay line with effective bandwidth greater than 200 $\div$ 300 $MH_z$ and tuneable over a wide frequency range (in principle from 2 $\div$ 16 $GH_z$ using YGH film).

The qualifying aspect of the invention is in the use of the devices instantaneous band frequency inversion technique, applied to a MSFVW dispensive line gives way to a down chirp rather than typical up chirp response. The invention will now be described as a non limiting illustration , with reference to the figures attached:

Figure 1 Schematic illustration of magnetostatic wave generation reported as an example case [1].

Figure 2 Schematic of the principle of frequency invention of a dispersive magnetos-

tatic wave up chirp delay line where:

(1) is the frequency generator (sweeper)

(2) and (4) are mixers;

(3) MSFVW dispersive delay line;

(5) local oscillator.

Figure 3 Bandwidth and phase graphs of the device as a function of frequency (1) of insertion loss (2), measured in dB and phase (3) curves where:

(a) is the up chirp MSFVW delay line;

(b) is the down chirp frequency inverted delay line where:

a) are attenutation and phase curves as a function of frequency of a MSFVW up chirp dispersive delay line;

b) is the down chirp frequency inverted attenutation, as above;

A) device attenutation in $dB_s$;

C) phase curve;

F) frequency (in $GH_z$);

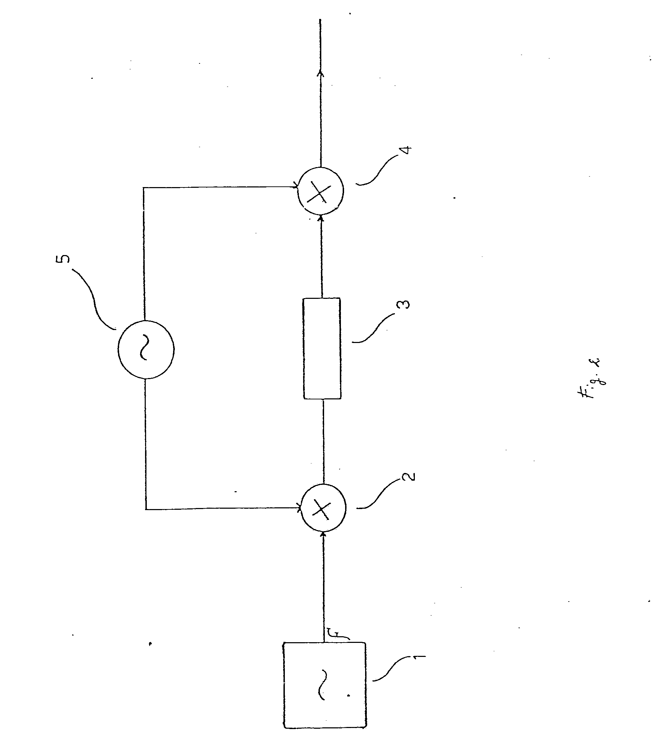

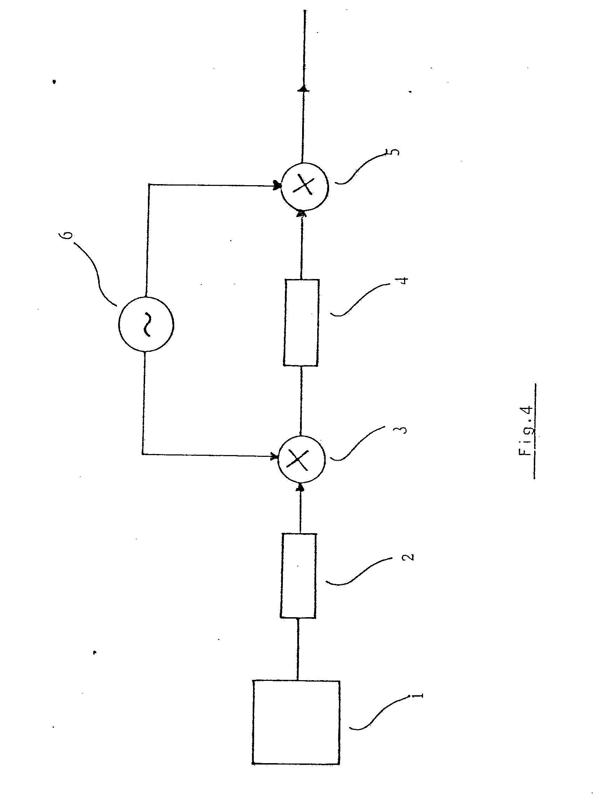

Figure 4 Circuit diagram of two conjugated dispersive delay line of the MSFVW type and cascaded, where (6) is the dispersive MSFVW up chirp delay line cascaded with the frequency inverted line (Fig. 2).

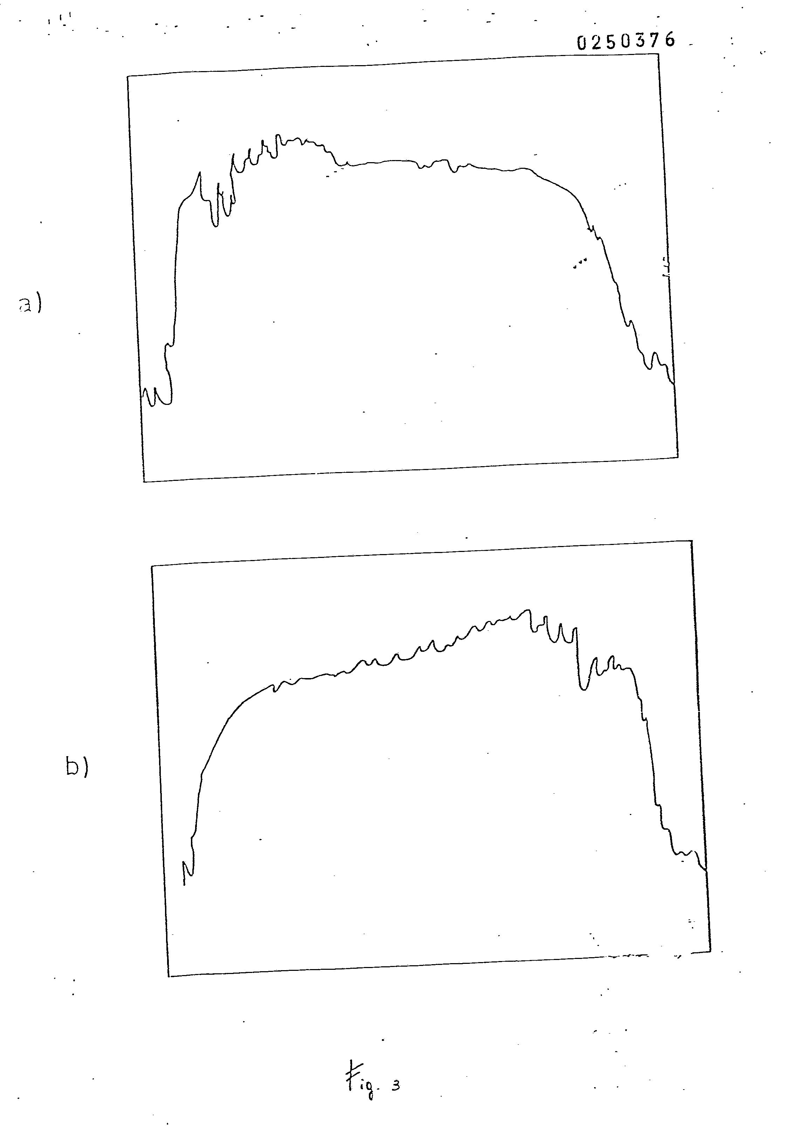

Note Figure 2: the up chirp dispersive MSFVW magnetostatic wave delay line (3) having instantaneous band from $f_1$ to $f_2$ (where $f_1$ $f_2$ ) is tuned to centre frequency $f_c$='$f_1$ +$f_2$ )/2. Frequency f signal picked out of variable generator sweeper) (1) and included in the $f_1 \div f_2$ interval is multiplied by mixer (2) with a signal generated by local oscillator (5) at fixed frequency $f_{LO}=2f_c$. Hence, the signal applied to the delay line (3) input has frequency $f_{LO}$-f, which is symmetrical to the frequency with respect to centre frequency $f_c$. This way dispersive line (3) introduces at measurement frequency f at mixer (2) input, the delay of symmetrical frequency $f_{LO}$-f. Completing the inversion process, putput signal of delay line (3) is multiplied by mixer (4) with local oscillator (5) signal so as to obtain once again the f frequency signal. Through iteration of such process for each frequency included in interval $f_1$ to $f_2$, the response for the whole instantaneous band is obtain as shown in the following fig. 3 (b).

Note Figure (3): Such figure shows the frequency response (in $GH_z$) of attenuation A (in dB) and phase curves (C) for:

(a) dispersive MSFW delay line (3) with up chirp response;

(b) the same delay to which the frequency inversion process of Fig. 2 has been applied. In this case, notwithstanding the use of delay line based upon progressive magnetostatic waves (MSFW), the response achieved is of the down-chirp type, as may be easily checked by observing the distribution of phase curves (c) as a function of frequency f and bearing in mind that the delay time per length unit is given by 1st derivative phase against frequency.

In the particular case, and not limiting, shown in figure 3, $f_1$ = 4.50 $GH_z$,$_z f_2$ = 5.2O$GH_z$, so that local oscillator frequency is $F_{LO}$ = 9.70 $GH_{z}$.$_z$

For the reasons above concerning MSFVW and MSBVW dispersive lines cascade and frequency inversion process, the above is a constant delay line, and may therefore be implemented using two identical dispersive delay lines of the MSFVW type, adopting two samples having the same dimensions derived the same YIG film and set on the same dielectric support, polarized by the same magnetic field $H_o$ normal to the sample plane. The detailed schematic is shown in Figure 4. Now note figure 4. This figure shows the circuit layout of two dispersive, conjugated, MSFVW cascaded delay lines. The group of two mixers (2) and (4), dispersive delay line (3) and local oscillator (5), make up a down chirp delay line, conjugated of delay line (6) which is of the up chirp type.

Consequently, the output of mixer (4) is characterized by a constant delay time for each frequency included in interval $f_1$ to $f_2$.

Finally, this invention makes possible the development of constant delay lines up to ~ 20 $Gh_z$, frequency limited by the local osciallator and mixers alone and based exclusively upon progressive magnetostatic volume waves.

This way, the instantaneous bandwidth of the device can be easily tuned by varying the intensity of the polarizing magnetic field $H_O$ alone. Furthermore the planar configuration gives way to greater compactness of the device, and therefore to a facilitated integration within structures containing the local oscillator, the mixers and possible microwave amplifiers.

References

[1] Method for the suppression of magnetic garnet film magnetostatic waves for microwave circuits. Italian Patent of the same applicant N. 47733 A/84.

[2] J.C. Sethares, J.M. Owens and R.L. Carter:
"MSW Non Dispersive Electronically Tunable Time Delay Elements" Electronic Letters 16, 825 (1980):

[3] L.R. Adkins, H.L. Glass, F.S. Stearns, R.L. Carter, K.W. Chang and J.M. Owens,
"Electronically Variable Time Delays using cascaded Magnetostatic Delay Lines" J. Appl. Phys 55 2518 (1984).

**Claims**

1. Method for the development at microwave frequencies (1-20$Gh_z$) of dispersive delay lines, characterized by being based on magnetic Yttrium and Iron garnet epitaxial films, which have a delay time of the doqn chirp type, obtained through frequency inversion of the up chirp dispersive lines magnetostatic band.

2. Method for the development of dispersive down chirp delay lines operating at microwave frequencies (1 $\div$ 20$Gh_z$) as per claim 1, where frequency inversion is applied to up chirp delay lines based upon volume progressive magnetostatic waves (MSFVW).

3. Method for the development of delay lines

with constant time delay as a function of frequency operating at microwave frequencies (1 ÷ 20 GHz), as per previous claims, which are obtained by cascading two dispersive delay lines, respectively of the up chirp and down chirp type.

4. Method for the development of constant delay lines as a function of frequency operating at microwave frequencies (1 ÷ 20 GHz), as per previous claims, where a down chirp dispersive delay line is obtained by converting the frequency response of a dispersive MSFVW up chirp line.

5. Method for the development of constant delay lines as a function of frequency operating at microwave frequencies (1 ÷ 20 GHz) as per claims 3 and 4, where device frequency tuning is achieved by varying a single external magnetic polarization field $H_o$.

6. Method for the development at microwave frequencies (1 ÷ 20 GHz) of constant delay lines as a function of frequency, as per claims 3,4 and 5, consisting in the cascading of two MSFVW planar dispersive delay lines set on the same dielectric support and where such lines are based upon two magnetic garnet samples obtained fron the same film.

7. Method for the development at microwave frequencies (1 ÷ 20 GHz) of dispersive delay lines, as per claims 1 and 2, through which two complete filters can be developed, the pulse response of which, in the frequency domain, $H_1$ (f) and $H_2$ (f) are one the conjugate of the other $H_2$ (f) = $H_1$ (f), as they consist of two identical dispersive MSFVW delay lines, based on the same Yttrium and Iron garnet film (or equivalent) to one of which lines, the frequency inversion technique is applied.

Fig.1

0250376

Fig. 2

0250376

a)

b)

Fig. 3

Fig.4

0250376